# EUROPEAN PATENT SPECIFICATION

(11) **EP 3 065 300 B1**
(45) Date of publication and mention of the grant of the patent: **24.01.2018**
(21) Application number: 16156956.1
(22) Date of filing: 23.02.2016
(51) Int. Cl.: G06F 3/06

(54) **METHODS AND APPARATUS FOR TWO-DIMENSIONAL BLOCK BIT-STREAM COMPRESSION AND DECOMPRESSION**
VERFAHREN UND VORRICHTUNG FÜR ZWEIDIMENSIONALE BLOCK-BITSTROMKOMPRESSION UND -DEKOMPRESSION
PROCÉDÉS ET APPAREIL POUR BLOC BIDIMENSIONNEL DE COMPRESSION ET DÉCOMPRESSION DE FLUX BINAIRE

(30) Priority: 28.02.2015 US 201514634757
(43) Date of publication of application: 07.09.2016
(73) Proprietor: Altera Corporation, San Jose, CA 95134 (US)
(72) Inventor: de la Cruz, Alfredo, San Jose, CA 95134 (US)
(74) Representative: Knöner, Gregor

(56) References cited:
- US-B1- 6 205 574
- US-B1- 6 327 634
- US-B1- 7 902 865

## Description

### BACKGROUND

### Technical Field

The present disclosure relates to the electronic configuration of integrated circuits.

### Description of the Background Art

A programmable logic device ("PLD") is a digital, user-configurable integrated circuit used to implement a custom logic function. PLDs have found particularly wide application as a result of their combined low up front cost and versatility to the user. For the purposes of this description, the term PLD encompasses any digital logic circuit configured by the end-user, and includes a programmable logic array ("PLA"), a field programmable gate array ("FPGA"), and an erasable and complex PLD.

The basic building block of a PLD is a logic element that is capable of performing logic functions on a number of input variables. The logic elements of a PLD may be arranged in groups of, for example, eight to form a larger logic array block ("LAB"). Multiple LABs (and other functional blocks, such as memory blocks, digital signal processing blocks, and so on) are generally arranged within a PLD core. The blocks may be separated by horizontal and vertical interconnect channels. Inputs and outputs of the LABs may be programmably connectable to horizontal and vertical interconnect channels.

Field programmable gate array devices are logic or mixed signal devices that may be configured to provide a user-defined function. FPGAs are typically configured by receiving data from a configuration stream supply device. This data may be referred to as a configuration bitstream or program object file. This bitstream opens and closes switches formed on an FPGA such that desired electrical connections are made.

The document US 6,327,634 B1 relates to the compression and decompression of configuration data for an FPGA. A bitstream corresponding to a configuration data file is compressed before loading the bitstream into a storage unit. The bitstream is then decompressed within the storage unit prior to forwarding the bitstream to the FPGA. The bitstream is for example compressed using the ZIP compression algorithm.

The document US 7,902,865 B1 relates to the compression and decompression of configuration data for programmable logic devices (PLDs) using repeated data frames. A compressed bitstream is created from the configuration data by embedding selected data frames and instructions to control the loading of such data frames into a configuration memory of the PLD.

### SUMMARY

The invention is defined in claims 1 and 7, respectively. Particular embodiments are set out in the dependent claims.

One aspect relates to a method for compressing a data-stream of configuration data for electronically configuring an electronically-programmable semiconductor device having a two-dimensional (2D) block structure for an array of core resources. Inter-block and intra-block transformations may be applied to the data-stream to obtain a 2D-transformed data-stream. Subsequently, one-dimensional (1D) compression that considers the configuration data as a sequence of bits (and does not consider the 2D block structure) may be applied to obtain a final compressed data sequence that is streamed to the electronically-programmable semiconductor device.

Another aspect relates to a method for decompressing a compressed data-stream to regenerate an original data-stream of configuration data for electronically configuring an electronically-programmable semiconductor device. The method may be performed by a decompression and reverse transformation module in the semiconductor device. A 1D decompression is applied to a final compressed data-stream to obtain a 1D-decompressed data-stream. 2D reverse transformation (i.e. 2D decompression) is then applied to the 1D-decompressed data-stream to recreate the original data-stream.

Another aspect relates to a system for compressing a data-stream of configuration data for electronically configuring an electronically-programmable semiconductor device. The system includes a transformation and compression module that applies the 2D compression (2D transformation) and 1D compression; and a configuration stream supply device that transmits the transformed and compressed data-stream to the electronically-programmable semiconductor device.

Another aspect relates to a semiconductor device that includes an array of core resources having a two-dimensional block structure and a decompression and reverse transformation module. The decompression and reverse transformation module regenerates an original data-stream of configuration data by steps including at least: receiving the compressed data-stream from a configuration stream supply device; applying 1D decompression to the compressed data-stream to obtain a 1D-decompressed data-stream; and applying 2D reverse transformation (2D decompression) to the 1D-decompressed data-stream to obtain a final decompressed data-stream that corresponds to the original data-stream.

Other embodiments, aspects, and features are also disclosed.

### BRIEF DESCRIPTION OF THE DRAWINGS

FIG. 1 is a simplified partial block diagram of an exemplary electronically-programmable semiconductor that may be electronically-configured in accordance with an embodiment of the present invention.
FIG. 2 is a block diagram of components of a system for electronically-configuring a programmable logic device in accordance with an embodiment of the invention.
FIG. 3 is a flow chart of an exemplary method of transforming and compressing a data stream for electronically configuring a programmable logic device in accordance with an embodiment of the invention.
FIG. 4 shows an exemplary block structure of configuration data for core resources in accordance with an embodiment of the invention.
FIG. 5 illustrates an exemplary block-fingerprint library based on the block structure in FIG. 4 in accordance with an embodiment of the invention.
FIG. 6 depicts an exemplary block-bitmap representation of the configuration data for the block structure in FIG. 4 in accordance with an embodiment of the invention.
FIG. 7 depicts the blocks of the core configuration data to which intra-block transformation is applied, and those to which intra-block transformation is applied, in accordance with an embodiment of the invention.
FIGS. 8A and 8B depict an exemplary block of configuration data before and after intra-block transformation, respectively, in accordance with an embodiment of the invention.
FIG. 9 is a flow chart of an exemplary method of decompressing and reverse transforming a data stream by an electronically-programmable semiconductor device in accordance with an embodiment of the invention.

### DETAILED DESCRIPTION

Complex FPGA devices use substantial amounts of configuration data to program all the user-desired functionality into the particular silicon device. This data set, commonly referred as bit-stream for historical reasons, is actually used to configure and program the multiple resources of the FPGA-hardware at the gate-level. As the sheer size of this data set keeps growing with each new generation of programmable devices, it is becoming a factor imposing usability limitations to the FPGA devices, not only because the increasing demands of non-volatile memory required to store this data; but also because the additional time demanded to read the configuration data onto the FPGA device, contributing to higher configuration times.

Configuration data characterizes itself by presenting long sequences of zeroes, normally corresponding to unused hardware resources within the device. Previous approaches have exploited this type of redundancy. Altera Corporation of San Jose, California, for example, has used a compression method which replaces each null-nibble (equal to 0000) by a "0" in a preceding control word; while a not null-nibble is represented by a "1", trailed by the actual nibble value. The compression rate of this approach is bounded to a theoretical maximum of four times. In accordance with the present disclosure, such a compression method is an example of a one-dimensional (1D) compression method because it does not require information as to the two-dimensional block structure of the circuitry in the integrated circuit.

The present disclosure provides an innovative approach to compressing and decompressing configuration data. The presently-disclosed approach takes advantage of the bit-oriented two-dimensional block structure of an FPGA core to provide increased compression ratios for real FPGA designs. The presently-disclosed approach may also be applied to other similarly structured electronically-programmable semiconductor devices.

### Exemplary Electronically-Programmable Semiconductor Device

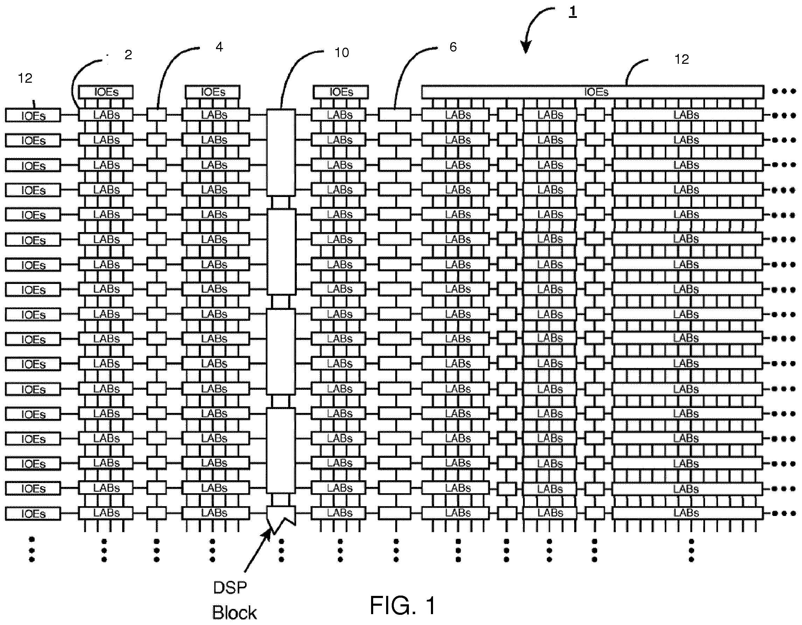

FIG. 1 is a simplified partial block diagram of an exemplary electronically-programmable semiconductor that may be electronically-configured in accordance with an embodiment of the present invention. In this case, the exemplary programmable device is a field programmable gate array (FPGA) 1. It should be understood that embodiments of the present invention can be used in numerous types of integrated circuits such as field programmable gate arrays (FPGAs), programmable logic devices (PLDs), complex programmable logic devices (CPLDs), programmable logic arrays (PLAs), and other electronically-programmable semiconductor devices.

FPGA 1 includes within its "core" a two-dimensional array of programmable logic array blocks (or LABs) 2 that are interconnected by a network of column and row interconnect conductors of varying length and speed. LABs 2 include multiple (e.g., ten) logic elements (or LEs).

An LE is a programmable logic block that provides for efficient implementation of user defined logic functions. An FPGA has numerous logic elements that can be configured to implement various combinatorial and sequential functions. The logic elements have access to a programmable interconnect structure. The programmable interconnect structure can be programmed to interconnect the logic elements in almost any desired configuration.

FPGA 1 may also include a distributed memory structure including random access memory (RAM) blocks of varying sizes provided throughout the array. The RAM blocks include, for example, blocks 4, and blocks 6. These memory blocks can also include shift registers and FIFO buffers.

FPGA 1 may further include digital signal processing (DSP) blocks that can implement, for example, multipliers with add or subtract features. Input/output elements (IOEs) 12 located, in this example, around the periphery of the chip support numerous single-ended and differential input/output standards. Each IOE 12 is coupled to an external terminal (i.e., a pin) of FPGA 10.

### System for Electronic Configuration of Semiconductor Device

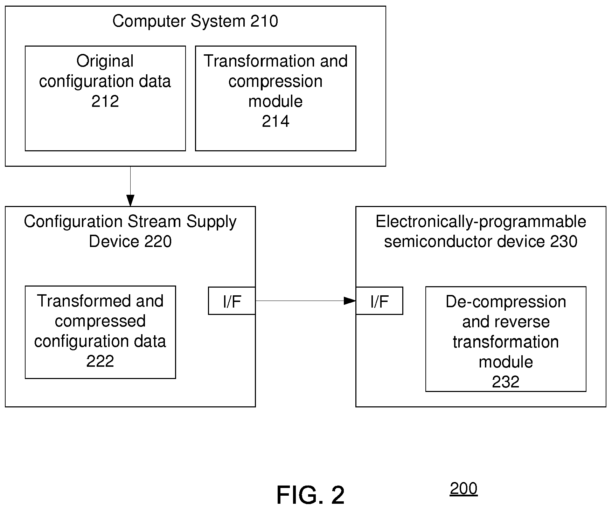

FIG. 2 is a block diagram of components of a system for electronic configuration of an electronically-programmable semiconductor device in accordance with an embodiment of the invention. As shown, the system 200 may include an electronically-programmable semiconductor device 230, a configuration stream supply device 220 and a computer system 210.

The computer system 210 may include original configuration data 212 for configuring the semiconductor device 230. In addition, the computer system 210 may include a transformation and compression module 214. The transformation and compression module 214 may be executed by a processor of the computer system 210 so as to transform and compress the original configuration data 212. The transformation and compression may involve 2D transformation (also referred to herein as 2D compression) followed by 1D compression, as described in the present disclosure.

The final compressed configuration data 222 may be sent from the computer system 210 to the configuration stream supply device 220 in sequential form as a data stream. Hence, in the present disclosure, the configuration data sequence is frequently referred to as a configuration data-stream.

The configuration stream supply device 220 may be, for example, a microcontroller which uses an embedded program to configure the semiconductor device 230, or a boot PROM which may be used to configure the semiconductor device 230 automatically upon power up. In a development environment, the configuration stream supply device 220 may be the computer system 210 (i.e. a separate configuration stream supply device 220 may not be needed).

The final compressed configuration data 222 may be streamed from the configuration stream supply device 220 to the electronically-programmable semiconductor device 230. For example, the electronically-programmable semiconductor device 230 may be an FPGA or similar device. Advantageously, the final compressed configuration data 222 may be substantially smaller in size than the original configuration data 212.

Within the electronically-programmable semiconductor device 230, the decompression and reverse transformation module 232 may be used to de-compress and reverse transform the final compressed configuration data 222 to obtain the original configuration data 212. The decompression and reverse transformation may involve 1D decompression and 2D reverse transformation (also referred to herein and 2D decompression). The original configuration data 212 may then be utilized to electronically configure the semiconductor device 230.

### Transformation and Compression of Configuration Data Stream

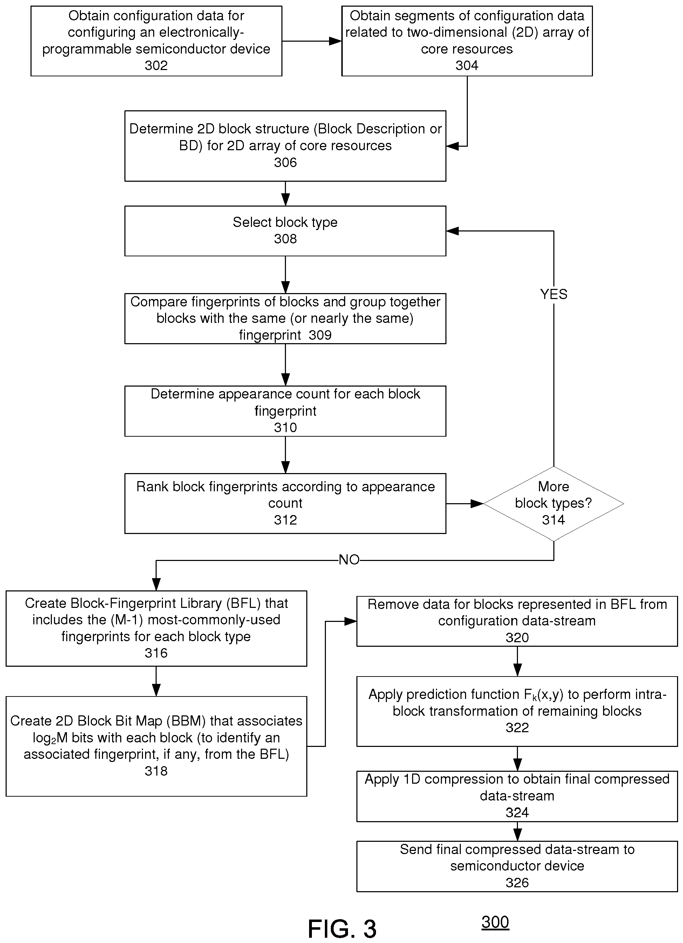

FIG. 3 is a flow chart of an exemplary method 300 of transforming and compressing a data stream for electronically configuring a programmable logic device in accordance with an embodiment of the invention. The method 300 may be performed, for example, by the transformation and compression module 214 of FIG. 2.

Per block 302, configuration data for configuring an electronically-programmable semiconductor device may be obtained. For example, the configuration data may be the original configuration data 212 of FIG. 2.

Configuration data in modern FPGAs comprises multiple data-segments, as a result of the complexity of these devices. A typical configuration data file includes segments related to peripheral resources (for example, input-output circuits, high-speed transceivers, and so on) and segments describing the configuration of a two-dimensional (2D) array of core resources.

Per step 304, segments of the configuration data related to the 2D array of core resources may be obtained. As described below, the method 300 transforms these core segments before application of 1D compression.

Per step 306, the 2D block structure for the 2D array of core resources is determined. Such a 2D block structure may be referred to herein as the "Block Descriptor" or "BD".

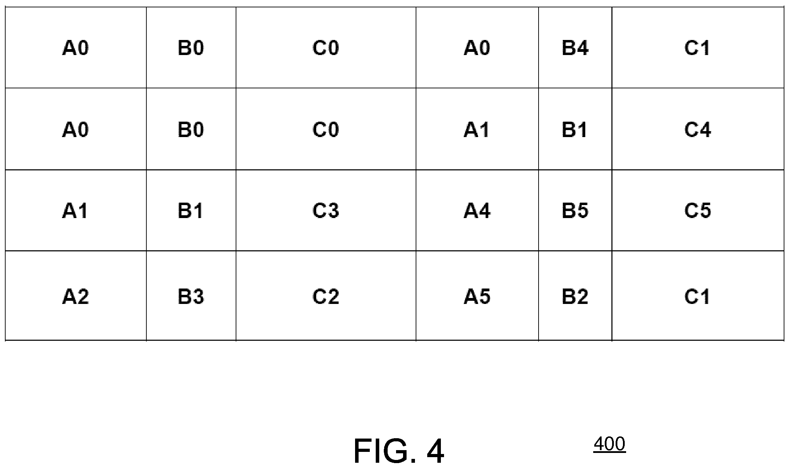

An exemplary 2D block structure for core resources is shown in FIG. 4. As depicted in FIG. 4, the blocks may be of multiple types, such as, for example: block type A (including blocks A0, A1, A2, A4 and A5), block type B (including blocks B0, B1, B2, B3, B4 and B5), and block type C (including blocks C0, C1, C2, C3, C4 and C5).

Note that the block definition may be selected so that the different block types may have different widths (as shown in FIG. 4) or so that the different block types share the same width (not shown). In the latter case, the columns of the 2D block structure would be of uniform width. In either case, the block definition (BD) is described in a compact form that is sent to, or already known by, the decompression and reverse transformation module 232.

The sequence of steps including steps 308 through 312 may be performed for each block type in the BD. Per step 308, a block type may be selected. For example, block type A may be first selected, and then later block types B and C may be selected.

Per step 309, "fingerprints" (bitmaps) of blocks of the selected type are compared, and blocks with the same (or nearly the same) fingerprint are grouped together (i.e. designated as being the "same" block). One clear example of a block fingerprint that may appear repeatedly is that of a block representing a default un-used state of an FPGA IP-resource block type.

In one embodiment, only blocks with identical fingerprints (bitmaps) are considered to be the "same" block and so grouped together. For example, in FIG. 4, the three blocks A0 may have bitmaps that are identical.

In another embodiment, blocks with very similar, but slightly different, fingerprints (i.e. "sibling" blocks) may also be grouped together as having the "same" fingerprint. For example, in FIG. 4, the three blocks A0 may be siblings, rather than being strictly identical. In that case, the small difference between the siblings (delta data) may also be determined and stored. For example, if only one or a few bits (or bytes) are different between two blocks, the delta data for the second (sibling) block may include the locations of those bits (or bytes) that are different compared with the first block.

Per step 310, an appearance count may be determined for each block fingerprint (including siblings, if applicable) within the set of blocks of the selected block type. For example, in FIG. 4, for block type A, the appearance count for block A0 is 3, for block A1 is 2, for block A2 is 1, for block A4 is 1, and for block A5 is 1.

Per step 312, the block fingerprints are ranked in descending order of appearance count, with the most frequently appearing ranking first. For example, in FIG. 4, for block type A, the ranking would be first (rank=1) block A0, second (rank=2) block A1, third (rank=3) block A2, fourth (rank=4) block A4 and fifth (rank=5) block A5 . Note that blocks A2, A4 and A5, each have an appearance count of one, so the ranking between them may be determined to be in a predetermined order (for example, by an order of appearance).

Per step 314, a determination may be made as to whether more block types in the BD are to be processed. If more block types are to be processed, then the method 300 may loop back to step 308 where a next block type is selected.

If all the block types have been processed, then the method 300 may move forward to the subsequent steps involving inter-block and intra-block transformations. As described below, inter-block transformation (steps 316 and 318) may be used to create a block-fingerprint library (BFL) and a 2D block bit map (BBM) so as to remove the data (step 320) for the (M-1) most-commonly-used block bitmaps of each block type. Furthermore, intra-block transformation (step 322) may be applied within the bitmaps of the remaining blocks not removed by the inter-block transformation.

### Inter-Block Transformation

Per step 316, a Block-Fingerprint Library (BFL) may be created. The BFL includes fingerprints of (M-1) most-commonly-used block bitmaps for each block type. In an exemplary implementation, the number M may be a power of two, such as 4, 8, 16, and so on. If siblings were grouped together, then the delta data for those (M-1) most-commonly-used block bitmaps may also be included in the BFL.

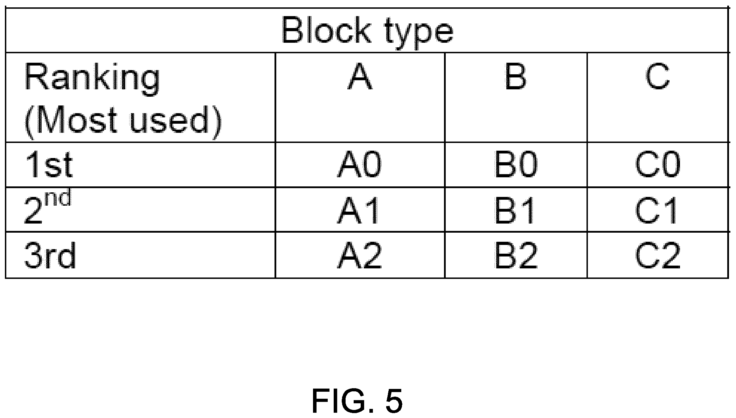

For example, consider M = 4, such that the BFL includes fingerprints (bitmaps) of the three (4 - 1 = 3) most-commonly-used block bitmaps of each block type. The content of such a BFL is shown by the table in FIG. 5. As shown in FIG. 5, the three most-commonly used block fingerprints are A0, A1, and A2 for block type A, B0, B1, and B2 for block type B, and C0, C1, and C2 for block type C.

Per step 318, a 2D block bit map (BBM) may be created. In one implementation, the BBM associates an identifying digital number having log₂ M bits with each block. For example, with M = 4, a two-bit digital number may be associated with each block via the BBM.

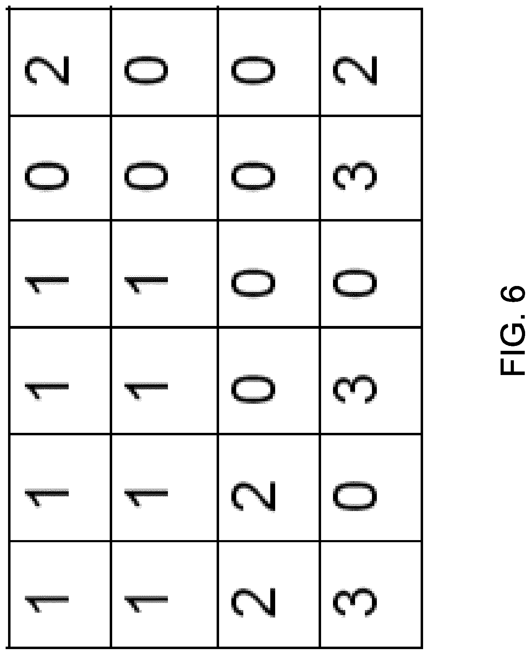

An example of such a BBM is provided in FIG. 6. As shown, the columns and rows in the BBM of FIG. 6 correspond to the columns and rows, respectively, in the 2D block structure of FIG. 4. Comparing FIGS. 4 and 6 shows that blocks A0, B0 and C0 in FIG. 4 have the identifying digital number 1 (binary 01) associated therewith in FIG. 6 due to their first ranking, blocks A1, B1 and C1 in FIG. 4 have the identifying digital number 2 (binary 10) associated therewith in FIG. 6 due to their second ranking, and blocks A2, B2 and C2 in FIG. 4 have the identifying digital number 3 (binary 11) associated therewith in FIG. 6 due to their third ranking. The remaining blocks in FIG. 4 have the identifying digital number 0 (binary 00) associated therewith in FIG. 6 to indicate that there is no fingerprint in the BFL associated therewith.

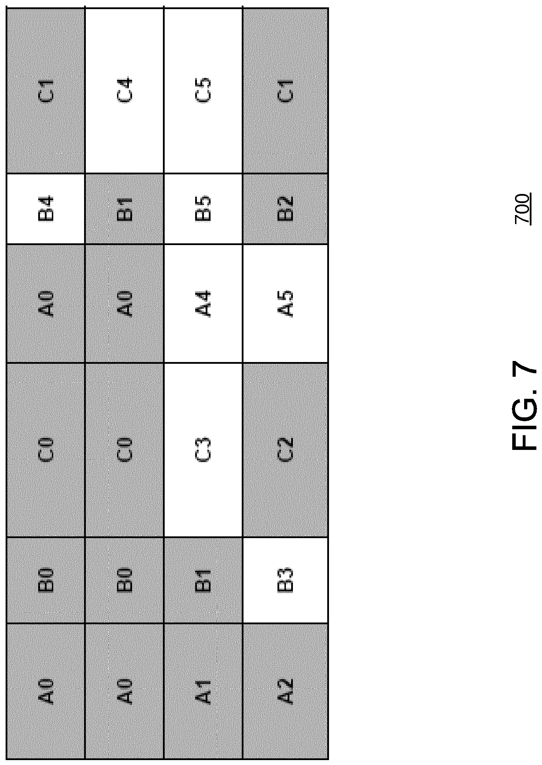

Per step 320, the data for blocks represented in the BFL may then be removed from the configuration data sequence. Intra-block transformation may be applied to the remaining blocks in the configuration data sequence. FIG. 7 depicts the blocks of the core configuration data to which intra-block transformation is applied in accordance with an embodiment of the invention. In the example described above, inter-block transformation is applied to the shaded blocks (A0, A1, A2, B0, B1, B2, C0, C1 and C2) and is not applied to the remaining (unshaded) blocks (A4, A5, B3, B4, B5, C3, C4 and C5).

### Intra-Block Transformation

Per step 322, an intra-block transformation may be applied within the bitmap of the blocks themselves to capture types of redundancy not captured with the inter-block transformation. In one implementation, the intra-block transformation is applied to blocks that are not represented within the BFL. In accordance with an embodiment of the invention, the intra-block transformation may utilize a bit-wise prediction of the configuration data based on adjacent bits inside the same block.

Complex silicon devices, such as FPGAs, generally use regular and repeatable design sub-block structures to generate complex design blocks. The size of these structures change from block-type to block-type, creating a singular pattern distance, for each block-type, in each of the x-y coordinates (for bits within a block). The compression algorithm described herein creates a prediction function Fₖ, where k is the total number of block types, which provides the bit-wise prediction for each block type 0, 1, 2, ..., k-1. In other words, Fₖ = Pred (Block_Type, x, y) is used to make a prediction, based on the block-type and the coordinates of the particular bit (x,y), of the value the actual bit in that position. To make that prediction, the function Fₖ is allowed to use information about neighbor bits in the range (x-R, x, y-R, y), where R is the number of rows stored by the predictor, from the particular blocks, as well as from adjacent identical blocks. As result, the function Fₖ returns a prediction on what the actual bit could be in location (x,y).

According to an embodiment of the present invention, the 2D intra-block transformation replaces the actual configuration bits within a block with a bit-result reflecting one of the two following situations: i) a 0-bit is delivered to the output if the actual configuration bit matches with the prediction made for that configuration position; and ii) a 1-bit is delivered to the output if the actual configuration bit does not match with the prediction made for that configuration position. This functionality may be achieved by using the following exemplary bit-operation: b_{x,y} = c_{x,y} XOR Fₖ(x,y), where b_{x,y} is the intra-sector transformed bit, c_{x,y} is the original configuration bit from location (x,y), Fₖ(x,y) is the prediction function (of the block types 0, 1, 2, ...k-1) that is applied to coordinates (x,y), and XOR is a bit-wise exclusive-or operation.

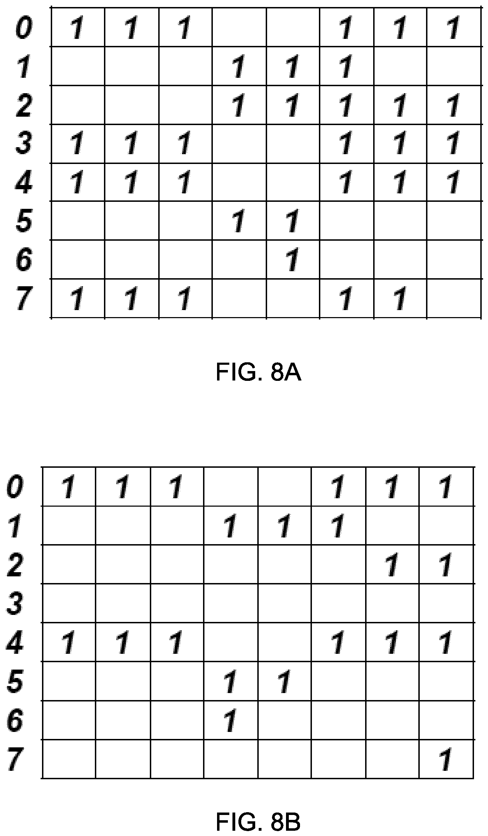

FIG. 8A depicts an exemplary block of configuration data before an intra-block transformation in accordance with an embodiment of the invention. Bits that have a value of one are shown as "1", and bits that have a value of zero are shown as blank. In this case, the prediction function Fₖ is used in which the pattern distance is four rows, such that each instance of the predictive pattern operates within four rows.

In this particular example, a first instance of the pattern is applied to Rows 0 to 3, and a second instance of the pattern is applied to Rows 4 to 7. Within the first instance, Row 0 is used to predict Row 3, and Row 1 is used to predict Row 2 (i.e. R0→R3 and R1→R2). Similarly, within the second instance, Row 4 is used to predict Row 7, and Row 5 is used to predict Row 6 (i.e. R4→R7 and R5→R6). Note that the above-discussed pattern is a relatively simple example of a predictive pattern that may be used. Other embodiments may use different predictive patterns.

The resulting bitmap after the intra-block transformation is shown in FIG. 8B. The bits in Rows 0, 1, 4 and 5 in FIG. 8B (the intra-transformed bitmap) are the same as the corresponding rows in FIG. 8A (the bitmap before intra-transformation) because those rows are used to predict bits in other rows (Rows 3, 2, 7 and 6, respectively), rather than being predicted by another row.

Row 3 of FIG. 8B includes only zero value bits because each bit value in Row 3 of FIG. 8A is the same as the corresponding bit value in Row 0 of FIG. 8A. Row 2 of FIG. 8B includes zero value bits in the first six columns and one value bits in the last two columns, because only the last two columns in Rows 2 and 3 of FIG. 8A differ from each other.

Row 7 of FIG. 8B includes zero value bits in the first seven columns and a one value bit in the last column, because only the last column in Rows 4 and 7 of FIG. 8A differ from each other. Row 6 of FIG. 8B includes one value bits only in the fourth column, because only the fourth column in Rows 5 and 6 of FIG. 8A have bit values that differ from each other.

In accordance with an embodiment of the invention, the pattern distance may be selected for each block type such that statistically good predictions can be made, so as to result in better compression rates. Note that the decompressor, in order to restore the original configuration bit, makes the same bit-wise prediction using the selected pattern distance for each block type and applies an XOR operation between its own prediction and the incoming bit. Note, further, that the procedure described above may be performed byte-wise or word-wise for efficiency of implementation.

In step 322, the intra-block transformation may be applied to all the remaining blocks in the data-stream (those blocks that were not removed in step 320). The resultant data-stream may be referred to as the 2D-transformed (post-transformation) data-stream. The 2D-transformed data-stream includes the BFL created in step 316, the BBM created in step 318, delta data for sibling blocks (if any), required information for the prediction function Fₖ (for example, selected pattern distances), and the intra-block transformed bitmaps per step 322. In addition, the 2D-transformed data-stream includes other configuration data needed to configure the electronically-programmable semiconductor device, such as configuration data for peripheral (non-core) circuits.

### One-Dimensional Compression

Per step 324, after the blocks of configuration data have been filtered by both types of 2D transformations, the resultant 2D-transformed data-stream may be further compressed using a 1D-compression procedure so as to obtain a final compressed data-stream. In an exemplary implementation, a Lempel-Ziv (LZ) type of 1D compression procedure may be used advantageously. In one implementation, the 1D compression is not applied to the BFL and the BBM, although the 1D compression may be applied to the BFL and the BBM in an alternate implementation.

In summary, the above-described compression technique applies both inter-block 2D compression and intra-block 2D compression to provide the combined effect of reducing the net size of the data source, as well as providing an increased amount of redundancy in the transformed data. Thereafter, 1D compression is advantageously applied to generate a final compressed data-stream that is substantially smaller than a compressed data-stream using 1D compression alone.

Finally, per step 326, the final compressed data-stream is sent to the electronically-programmable semiconductor device 230. In one embodiment, prior to being transmitted, the 1D-compressed post-transformation data-stream 222 may be sent to, and stored in, a configuration stream supply device 220, such as illustrated in FIG. 2. The configuration stream supply device 220 may then transmit the final compressed data-stream to the electronically-programmable semiconductor device 230. As described further below, a decompression and reverse transformation module 232 in the electronically-programmable semiconductor device 230 decompresses and reverse transforms the data-stream so that the original data-stream may be used to electronically configure the circuits within the semiconductor device 230.

### Reverse Transformation and Decompression

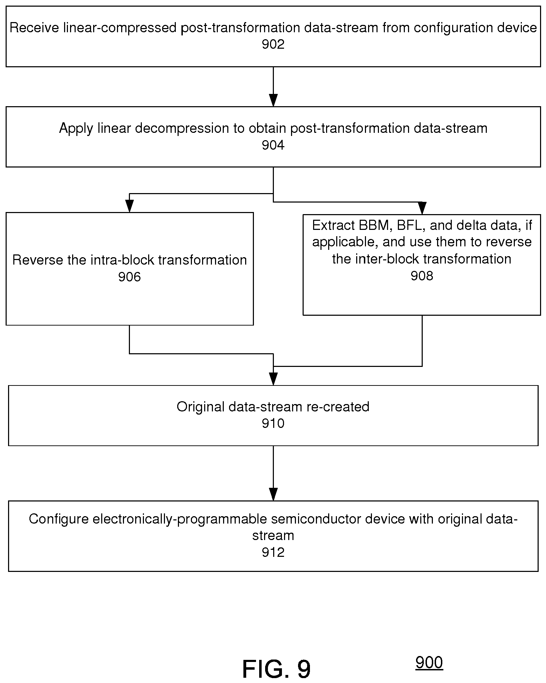

FIG. 9 is a flow chart of an exemplary method 900 of decompressing and reverse transforming a data stream by an electronically-programmable semiconductor device in accordance with an embodiment of the invention. The method 900 may be performed, for example, by the decompression and reverse transformation and compression module 232 of FIG. 2.

Per step 902, the final compressed post-transformation data-stream is received by the semiconductor device. In one embodiment, the final compressed post-transformation data-stream is received by the semiconductor device 230 from the configuration stream supply device 220.

Per step 904, 1D decompression is applied to portions of the final compressed data-stream that were 1D compressed by the transformation and compression module 214. As a result, a 1D-decompressed data-stream is obtained or regenerated. The 1D-decompressed data-stream corresponds to the 2D-transformed data-stream described above in relation to the transformation and compression procedure 300. As described above, the 1D-decompressed data-stream includes the BFL, the BBM, delta data for sibling blocks (if any), required information for the prediction function Fₖ (for example, selected pattern distances), and the intra-block transformed bitmaps. In addition, the 1D-decompressed data-stream includes other configuration data needed to configure the electronically-programmable semiconductor device, such as configuration data for peripheral (non-core) circuits.

Next, the 2D reverse transformation (2D decompression) may be applied to the 1D-decompressed data-stream. The 2D reverse transformation includes both the Inter-block and Intra-block reverse transformations. Note that the algorithm described herein does not strictly require sequential decompression of Inter-block and Intra-block reverse transformations. Such ordering is valid for the transformations performed by the compressor, because of the priority of full-matching blocks, but not for the reverse transformations performed by the decompressor. In fact, during decompression, the Intra-block reverse transformation (step 906) and the Inter-Sector reverse transformation (step 908) may be performed in parallel.

Per step 906, the prediction function Fₖ is used to reverse the intra-block transformation of the blocks that was done by the transformation and compression module 214 so as to obtain the original blocks. Note that, in one implementation, since the intra-block transformation by the compressor and the reverse intra-block transformation by the decompressor are not applied to the blocks represented within the BFL; they are applied only to the blocks not represented within the BFL. In the example intra-block transformation described above in relation to FIGS. 8A and 8B, the original configuration bit may be regenerated by applying an XOR operation to the intra-block transformed and predicted bits. In other words, c_{x,y} = b_{x,y} XOR Fₖ(x,y).

Per step 908, which may be performed in parallel to step 906, the BBM, BFL, and the delta data for siblings (if applicable) are extracted and used to reverse the inter-block transformation. The BBM is used as a guide to determine which blocks are to be copied from the BFL to positions in the data-stream indicated by the BBM, and the delta data is applied to make the adjustments to re-create the sibling blocks, if applicable.

As a result of steps 906 and 908, the original segments of the configuration data for the 2D array of core resources are regenerated. This results in the recreation of the original data-stream per step 910. The original data-stream may then be used to electronically configure the semiconductor device 230 per step 912.

### Alternative Embodiments

Embodiment 1. A method for decompressing a data-stream to regenerate an original data-stream of configuration data for electronically configuring an electronically-programmable semiconductor device which includes a two-dimensional block structure for an array of core resources of the electronically-programmable semiconductor device, wherein the two dimensional block structure includes a plurality of block types, and wherein blocks belonging to a same block type have a same width and a same length in bits, the method being performed by a decompression and reverse transformation module in the electronically-programmable semiconductor device and comprising:
receiving the data-stream from a configuration stream supply device;
extracting a block fingerprint library and a block bit map from the data-stream; and
inserting copies of blocks from the block fingerprint library as identified by the block bit map into the data-stream at positions indicated by the block bit map.

Embodiment 2. The method of Embodiment 1, wherein the block fingerprint library includes a plurality of most-commonly-used block fingerprints for each of the plurality of block types.

Embodiment 3. The method of Embodiment 2, wherein the block bit map associates a plurality of bits with each block of the two-dimensional block structure, wherein the plurality of bits indicates which of the plurality of most-commonly-used block fingerprints, if any, is associated with said block.

Embodiment 4. The method of Embodiment 1, 2 or 3, further comprising:
reversing intra-block transformation of remaining blocks in the data stream that are not in the block fingerprint library using an inverse prediction function.

Embodiment 5. The method of Embodiment 4, wherein the inverse prediction function depends on a plurality of pattern distances corresponding to the plurality of block types.

Embodiment 6. The method of Embodiment 4 or 5, further comprising:
applying one-dimensional decompression to the remaining blocks, wherein the one-dimensional decompression does not require information of the two-dimensional block structure.

Embodiment 7. A semiconductor device comprising:
an array of core resources having a two-dimensional block structure;
a decompression and reverse transformation module that regenerates an original data-stream of configuration data by performing steps including:
   receiving a data-stream from a configuration stream supply device;
   performing a one-dimensional decompression on a portion of the data-stream, wherein the one-dimensional decompression does not require information of the two-dimensional block structure; and
   performing a reverse intra-block transformation on said portion of the data-stream.

Embodiment 8. The semiconductor device of Embodiment 7, wherein the steps performed by the decompression and reverse transformation module further include: performing a reverse inter-block transformation by extracting a block fingerprint library and a block bit map from the data-stream, and inserting copies of blocks from the block fingerprint library as identified by the block bit map into the data-stream at positions indicated by the block bit map.

Embodiment 9. The semiconductor device of Embodiment 8, wherein the reverse intra-block transformation and the reverse inter-block transformation are performed in parallel.

### Conclusion

In the above description, numerous specific details are given to provide a thorough understanding of embodiments of the invention. However, the above description of illustrated embodiments of the invention is not intended to be exhaustive or to limit the invention to the precise forms disclosed. One skilled in the relevant art will recognize that the invention can be practiced without one or more of the specific details, or with other methods, components, etc.

In other instances, well-known structures or operations are not shown or described in detail to avoid obscuring aspects of the invention. While specific embodiments of, and examples for, the invention are described herein for illustrative purposes, various equivalent modifications are possible within the scope of the invention, as those skilled in the relevant art will recognize. These modifications may be made to the invention in light of the above detailed description.

## Claims

1. A method for compressing a data-stream of configuration data (212) for electronically configuring an electronically-programmable semiconductor device (230), the method (300) being performed by a transformation and compression module (214), the method being **characterized by** comprising:
determining (306) in the configuration data (212) a two-dimensional block structure for an array of core resources of the electronically-programmable semiconductor device (230), wherein the two-dimensional block structure includes a plurality of block types, and wherein blocks belonging to a same block type have a same width and a same length in bits, and wherein each block has a block fingerprint corresponding to content of the block;
determining (310, 312) a plurality of most-commonly-used block fingerprints for each block type of the plurality of block types; and
creating (316) a block fingerprint library that includes the plurality of most-commonly-used block fingerprints for each block type.

2. The method of claim 1, further comprising:
removing (320) from the data-stream blocks which are expressed by any one of the plurality of most-commonly-used block fingerprints for the plurality of block types; and
inserting the block fingerprint library into the data-stream at a position before the removed blocks.

3. The method of claim 2, further comprising:
creating (318) a block bit map that associates a plurality of bits with each block of the two-dimensional block structure, wherein the plurality of bits indicates which of the plurality of most-commonly-used block fingerprints, if any, is associated with said block; and
inserting a block descriptor and the block bit map into the data-stream at a position before the removed blocks.

4. The method of claim 3, further comprising:
applying (322) an intra-block transform to blocks remaining in the data-stream using a prediction function.

5. The method of claim 4, wherein the prediction function depends on a plurality of pattern distances corresponding to the plurality of block types.

6. The method of claim 4 or 5, further comprising:
applying (324) a one-dimensional compression to the data-stream after application of the intra-block transform, wherein the one-dimensional compression does not require information of the two-dimensional block structure.

7. A system for compressing a data-stream of configuration data (212) for electronically configuring an electronically-programmable semiconductor device (230), wherein the system is **characterized by** comprising:
a transformation and compression module (214) that generates a transformed and compressed data-stream by performing steps including:
determining (306) in the configuration data (212) a two-dimensional block structure for a two-dimensional array of core resources of the semiconductor device (230), wherein the two-dimensional block structure includes a plurality of block types, and wherein blocks belonging to a same block type have a same width and a same length in bits, and wherein each block has a block fingerprint corresponding to content of the block;
determining (310, 312) a plurality of most-commonly-used block fingerprints for each block type; and
creating (316) a block fingerprint library that includes the plurality of most-commonly-used block fingerprints for each block type; and
a configuration stream supply device (220) that transmits the transformed and compressed data-stream to the electronically-programmable semiconductor device (230).

8. The system of claim 7, wherein the steps performed by the transformation and compression module (214) further include:
removing (320) from the data-stream blocks which are expressed by any one of the plurality of most-commonly-used block fingerprints for the plurality of block types; and
inserting the block fingerprint library into the data-stream at a position before the removed blocks.

9. The system of claim 8, wherein the steps performed by the transformation and compression module (214) further include:
creating (318) a block bit map that associates a plurality of bits with each block of the two-dimensional block structure, wherein the plurality of bits indicates which of the plurality of most-commonly-used block fingerprints, if any, is associated with said block; and
inserting a block descriptor and the block bit map into the data-stream at a position before the removed blocks.

10. The system of claim 9, wherein the steps performed by the transformation and compression module (214) further include:
applying (322) an intra-block transform to blocks remaining in the data-stream using a prediction function.

11. The system of claim 10, wherein the prediction function depends on a plurality of pattern distances corresponding to the plurality of block types.

12. The system of claim 10 or 11, wherein the steps performed by the transformation and compression module (214) further include:
applying (324) a one-dimensional compression to the data-stream after application of the intra-block transform, wherein the one-dimensional compression does not require information of the two-dimensional block structure.

## Patentansprüche

1. Verfahren zum Komprimieren eines Datenstroms von Konfigurationsdaten (212) zum elektronischen Konfigurieren einer elektronisch programmierbaren Halbleitervorrichtung (230), wobei das Verfahren (300) durch ein Transformations- und Kompressionsmodul (214) ausgeführt wird, wobei das Verfahren **gekennzeichnet ist durch**:
Bestimmen (306) in den Konfigurationsdaten (212) einer zweidimensionalen Blockstruktur für eine Anordnung von Kernbetriebsmitteln der elektronisch programmierbaren Halbleitervorrichtung (230), wobei die zweidimensionale Blockstruktur mehrere Blocktypen enthält und wobei Blöcke, die zum selben Blocktyp gehören, die gleiche Breite und die gleiche Länge in Bits haben und wobei jeder Block einen Blockfingerabdruck besitzt, der dem Inhalt des Blocks entspricht;
Bestimmen (310, 312) mehrerer am häufigsten verwendeter Blockfingerabdrücke für jeden Blocktyp der mehreren Blocktypen; und
Erzeugen (316) einer Blockfingerabdruck-Bibliothek, die die mehreren am häufigsten verwendeten Blockfingerabdrücke für jeden Blocktyp enthält.

2. Verfahren nach Anspruch 1, das ferner Folgendes umfasst:
Entfernen (320) von Blöcken, die durch irgendeinen der mehreren am häufigsten verwendeten Blockfingerabdrücke für die mehreren Blocktypen ausgedrückt werden, aus dem Datenstrom; und
Einsetzen der Blockfingerabdruck-Bibliothek in den Datenstrom an einer Position vor den entfernten Blöcken.

3. Verfahren nach Anspruch 2, das ferner Folgendes umfasst:
Erzeugen (318) einer Block-Bitmap, die jedem Block der zweidimensionalen Blockstruktur mehrere Bits zuordnet, wobei die mehreren Bits angeben, welcher der mehreren am häufigsten verwendeten Blockfingerabdrücke, falls vorhanden, dem Block zugeordnet ist; und
Einsetzen eines Blockdeskriptors und der Block-Bitmap in den Datenstrom an einer Position vor den entfernten Blöcken.

4. Verfahren nach Anspruch 3, das ferner Folgendes umfasst:
Anwenden (322) einer blockinternen Transformation auf Blöcke, die in dem Datenstrom verbleiben, unter Verwendung einer Vorhersagefunktion.

5. Verfahren nach Anspruch 4, wobei die Vorhersagefunktion von mehreren Musterabständen, die den mehreren Blocktypen entsprechen, abhängt.

6. Verfahren nach Anspruch 4 oder 5, das ferner Folgendes umfasst:
Anwenden (324) einer eindimensionalen Kompression auf den Datenstrom nach dem Anwenden der blockinternen Transformation, wobei die eindimensionale Kompression keine Informationen über die zweidimensionale Blockstruktur erfordert.

7. System zum Komprimieren eines Datenstroms von Konfigurationsdaten (212) zum elektronischen Konfigurieren einer elektronisch programmierbaren Halbleitervorrichtung (230), wobei das System **gekennzeichnet ist durch**:
ein Transformations- und Kompressionsmodul (214), das **durch** Ausführen der folgenden Schritte einen transformierten und komprimierten Datenstrom erzeugt, wobei die Schritte Folgendes umfassen:
Bestimmen (306) in den Konfigurationsdaten (212) einer zweidimensionalen Blockstruktur für eine zweidimensionale Anordnung von Kernbetriebsmitteln der Halbleitervorrichtung (230), wobei die zweidimensionale Blockstruktur mehrere Blocktypen enthält und wobei Blöcke, die zu demselben Blocktyp gehören, die gleiche Breite und die gleiche Länge in Bits haben und wobei jeder Block einen Blockfingerabdruck besitzt, der dem Inhalt des Blocks entspricht;
Bestimmen (310, 312) mehrerer am häufigsten verwendeter Blockfingerabdrücke für jeden Blocktyp; und
Erzeugen (316) einer Blockfingerabdruck-Bibliothek, die die mehreren am häufigsten verwendeten Blockfingerabdrücke für jeden Blocktyp enthält; und
eine Konfigurationsstrom-Übertragungsvorrichtung (220), die den transformierten und komprimierten Datenstrom an die elektronisch programmierbare Halbleitervorrichtung (230) überträgt.

8. System nach Anspruch 7, wobei die Schritte, die durch das Transformations- und Kompressionsmodul (214) ausgeführt werden, ferner Folgendes umfassen:
Entfernen (320) von Blöcken, die durch irgendeinen der mehreren am häufigsten verwendeten Blockfingerabdrücke für die mehreren Blocktypen ausgedrückt werden, aus dem Datenstrom; und
Einsetzen der Blockfingerabdruck-Bibliothek in den Datenstrom an einer Position vor den entfernten Blöcken.

9. System nach Anspruch 8, wobei die Schritte, die durch das Transformations- und Kompressionsmodul (214) ausgeführt werden, ferner Folgendes umfassen:
Erzeugen (318) einer Block-Bitmap, die jedem Block der zweidimensionalen Blockstruktur mehrere Bits zuordnet, wobei die mehreren Bits angeben, welcher der mehreren am häufigsten verwendeten Fingerabdrücke, falls vorhanden, dem Block zugeordnet ist; und
Einsetzen eines Blockdeskriptors und der Block-Bitmap in den Datenstrom an einer Position vor den entfernten Blöcken.

10. System nach Anspruch 9, wobei die Schritte, die durch das Transformations- und Kompressionsmodul (214) ausgeführt werden, ferner Folgendes umfassen:
Anwenden (322) einer blockinternen Transformation auf Blöcke, die in dem Datenstrom verbleiben, unter Verwendung einer Vorhersagefunktion.

11. System nach Anspruch 10, wobei die Vorhersagefunktion von mehreren Musterabständen, die den mehreren Blocktypen entsprechen, abhängt.

12. System nach Anspruch 10 oder 11, wobei die Schritte, die durch das Transformations- und Kompressionsmodul (214) ausgeführt werden, ferner Folgendes umfassen:
Anwenden (324) einer eindimensionalen Kompression auf den Datenstrom nach der Anwendung der blockinternen Transformation, wobei die eindimensionale Kompression keine Informationen über die zweidimensionale Blockstruktur erfordert.

## Revendications

1. Procédé de compression d'un flux de données de données de configuration (212) permettant la configuration électronique d'un dispositif semi-conducteur programmable électroniquement (230), le procédé (300) étant mis en oeuvre par un module de transformation et de compression (214), le procédé étant **caractérisé en ce qu'**il comprend les étapes suivantes :
détermination (306), dans les données de configuration (212), d'une structure de blocs bidimensionnelle pour un réseau de ressources de coeur du dispositif semi-conducteur programmable électroniquement (230), la structure de blocs bidimensionnelle comportant une pluralité de types de blocs, et des blocs appartenant à un même type de blocs possédant une même largeur et une même longueur en bits, et chaque bloc possédant une empreinte de bloc correspondant à un contenu du bloc ;
détermination (310, 312) d'une pluralité d'empreintes de blocs les plus couramment utilisées pour chaque type de blocs de la pluralité de types de blocs ; et
création (316) d'une bibliothèque d'empreintes de blocs comportant la pluralité d'empreintes de blocs les plus couramment utilisées pour chaque type de blocs.

2. Procédé selon la revendication 1, comprenant en outre les étapes suivantes :
suppression (320), du flux de données, de blocs exprimés par l'une quelconque de la pluralité d'empreintes de blocs les plus couramment utilisées pour la pluralité de types de blocs ; et
insertion de la bibliothèque d'empreintes de blocs dans le flux de données en une position qui précède les blocs supprimés.

3. Procédé selon la revendication 2, comprenant en outre les étapes suivantes :
création (318) d'une table de bits de bloc qui associe une pluralité de bits à chaque bloc de la structure de blocs bidimensionnelle, la pluralité de bits indiquant laquelle de la pluralité d'empreintes de blocs les plus couramment utilisées, s'il en existe une, est associée audit bloc ; et
insertion d'un descripteur de bloc et de la table de bits de bloc dans le flux de données en une position qui précède les blocs supprimés.

4. Procédé selon la revendication 3, comprenant en outre l'étape suivants :
application (322) d'une transformation intra-bloc à des blocs restants dans le flux de données à l'aide d'une fonction de prédiction.

5. Procédé selon la revendication 4, dans lequel la fonction de prédiction dépend d'une pluralité de distances de modèle correspondant à la pluralité de types de blocs.

6. Procédé selon la revendication 4 ou 5, comprenant en outre l'étape suivants :
application (324) d'une compression unidimensionnelle au flux de données suite à l'étape d'application de la transformation intra-bloc, la compression unidimensionnelle ne nécessitant pas d'informations sur la structure de blocs bidimensionnelle.

7. Système de compression d'un flux de données de données de configuration (212) permettant la configuration électronique d'un dispositif semi-conducteur programmable électroniquement (230), le système étant **caractérisé en ce qu'**il comprend :
un module de transformation et de compression (214) générant un flux de données transformé et comprimé en accomplissant des étapes comportant les étapes suivantes :
détermination (306), dans les données de configuration (212), d'une structure de blocs bidimensionnelle pour un réseau bidimensionnel de ressources de coeur du dispositif semi-conducteur (230), la structure de blocs bidimensionnelle comportant une pluralité de types de blocs, et des blocs appartenant à un même type de blocs possédant une même largeur et une même longueur en bits, et chaque bloc possédant une empreinte de bloc correspondant à un contenu du bloc ;
détermination (310, 312) d'une pluralité d'empreintes de blocs les plus couramment utilisées pour chaque type de blocs ; et
création (316) d'une bibliothèque d'empreintes de blocs comportant la pluralité d'empreintes de blocs les plus couramment utilisées pour chaque type de blocs ; et
un dispositif de fourniture de flux de configuration (220) transmettant le flux de données transformé et comprimé au dispositif semi-conducteur programmable électroniquement (230).

8. Système selon la revendication 7, dans lequel les étapes accomplies par le module de transformation et de compression (214) comportent en outre les étapes suivantes :
suppression (320), du flux de données, de blocs exprimés par l'une quelconque de la pluralité d'empreintes de blocs les plus couramment utilisées pour la pluralité de types de blocs ; et
insertion de la bibliothèque d'empreintes de blocs dans le flux de données en une position qui précède les blocs supprimés.

9. Système selon la revendication 8, dans lequel les étapes accomplies par le module de transformation et de compression (214) comportent en outre les étapes suivantes :
création (318) d'une table de bits de bloc qui associe une pluralité de bits à chaque bloc de la structure de blocs bidimensionnelle, la pluralité de bits indiquant laquelle de la pluralité d'empreintes de blocs les plus couramment utilisées, s'il en existe une, est associée audit bloc ; et
insertion d'un descripteur de bloc et de la table de bits de bloc dans le flux de données en une position qui précède les blocs supprimés.

10. Système selon la revendication 9, dans lequel les étapes accomplies par le module de transformation et de compression (214) comportent en outre les étapes suivantes :
application (322) d'une transformation intra-bloc à des blocs restants dans le flux de données à l'aide d'une fonction de prédiction.

11. Système selon la revendication 10, dans lequel la fonction de prédiction dépend d'une pluralité de distances de modèle correspondant à la pluralité de types de blocs.

12. Système selon la revendication 10 ou 11, dans lequel les étapes accomplies par le module de transformation et de compression (214) comportent en outre les étapes suivantes :
application (324) d'une compression unidimensionnelle au flux de données suite à l'étape d'application de la transformation intra-bloc, la compression unidimensionnelle ne nécessitant pas d'informations sur la structure de blocs bidimensionnelle.
